# EUROPÄISCHE PATENTANMELDUNG

(11) **EP 4 040 505 A1**
(43) Veröffentlichungstag der Anmeldung: **10.08.2022**
(21) Anmeldenummer: 22000023.6
(22) Anmeldetag: 01.02.2022
(51) Int. Cl.: H01L 29/861, H01L 29/20, H01L 29/36

(54) **STAPELFÖRMIGE III-V-HALBLEITERDIODE**

(30) Priorität: 08.02.2021 DE 102021000611
(71) Anmelder: 3-5 Power Electronics GmbH, 01217 Dresden (DE)
(72) Erfinder: Kowalsky, Jens, 15859 Storkow (DE); Bhojani, Riteshkumar, 09126 Chemnitz (DE); Dudek, Volker, 76275 Ettlingen (DE)
(74) Vertreter: Koch Müller Patentanwaltsgesellschaft mbH

(57) **Zusammenfassung**

Stapelförmige III-V-Halbleiterdiode umfassend oder bestehend aus GaAs, aufweisend eine hoch n-dotierte Kathodenschicht, eine hoch p-dotierte Anodenschicht und ein zwischen der Kathodenschicht und der Anodenschicht angeordnetes Driftgebiet mit einer Dotierstoffkonzentration von höchstens 8•10¹⁵ cm⁻³, wobei das Driftgebiet eine niedrig n-dotierte Driftschicht und eine zwischen der n-dotierten Driftschicht und der Anodenschicht angeordnete niedrig p-dotierte Driftschicht aufweist, beide Driftschichten jeweils eine Schichtdicke von mindestens 5 µm aufweisen, die Kathodenschicht einen ersten Abschnitt mit einer Dotierstoffkonzentration von mindestens 1•10¹⁷ cm⁻³ und einen zwischen dem ersten Abschnitt und dem Driftgebiet angeordneten zweiten Abschnitt aufweist, der zweite Abschnitt eine Schichtdicke von mindestens 1 µm und einen in Richtung des ersten Abschnitts bis zu einem Dotierstoffkonzentrationsmaximum ansteigenden Dotierstoffkonzentrationsverlauf aufweist und das Dotierstoffkonzentratlonsmaximum kleiner oder gleich der Dotierstoffkonzentration des ersten Abschnitts ist.

## Beschreibung

Die Erfindung betrifft eine stapelförmige III-V-Halbleiterdiode umfassend oder bestehend aus GaAs mit einer hoch n-dotierten Kathodenschicht, einer hoch p-dotierten Anodenschicht und einem zwischen der Kathodenschicht und der Anodenschicht angeordneten Driftgebiet.

Eine hochspannungsfeste Halbleiterdiode mit einer p⁺ - n - n⁺ Struktur aus Galliumarsenid ist aus "GaAs Power Devices" von German Ashkinazi, ISBN 965-7094-19-4, Seite 8 und 9 bekannt.

Weitere stapelförmige III-V-Halbleiterdioden sind aus der EP 3 321 971 B1 sowie aus der EP 3 321 970 B1 bekannt, wobei die Halbleiterdioden eine zusätzliche Zwischenschicht zwischen dem Driftgebiet und der Kathode bzw. Anode aufweisen.

Vor diesem Hintergrund besteht die Aufgabe der Erfindung darin, eine Vorrichtung anzugeben, die den Stand der Technik weiterbildet.

Die Aufgabe wird durch eine stapelförmige III-V-Halbleiterdiode mit den Merkmalen des Patentanspruchs 1 gelöst. Vorteilhafte Ausgestaltungen der Erfindung sind Gegenstand von Unteransprüchen.

In dem Gegenstand der Erfindung wird eine stapelförmige III-V-Halbleiterdiode umfassend oder bestehend aus GaAs bereitgestellt, aufweisend eine hoch n-dotierte Kathodenschicht, eine hoch p-dotierte Anodenschicht und ein zwischen der Kathodenschicht und der Anodenschicht angeordnetes Driftgebiet mit einer Dotierstoffkonzentration von höchstens 8•10¹⁵ cm⁻³.

Das Driftgebiet weist eine niedrig n-dotierte Driftschicht und eine zwischen der n-dotierten Driftschicht und der Anodenschicht angeordnete niedrig p-dotierte Driftschicht auf, wobei beide Driftschichten jeweils eine Schichtdicke von mindestens 5 µm aufweisen.

Die Kathodenschicht weist einen ersten Abschnitt mit einer konstanten oder zumindest im Wesentlichen konstanten Dotierstoffkonzentration von mindestens 1•10¹⁷ cm⁻³ oder von mindestens 1•10¹⁸ cm⁻³ und einen zwischen dem ersten Abschnitt und dem Driftgebiet angeordneten zweiten Abschnitt auf.

Der zweite Abschnitt weist eine Schichtdicke von mindestens 1 µm und einen in Richtung des ersten Abschnitts bis zu einem Dotierstoffkonzentrationsmaximum ansteigenden Dotierstoffkonzentrationsverlauf auf.

Das Dotierstoffkonzentrationsmaximum des zweiten Abschnitts ist kleiner oder gleich der Dotierstoffkonzentration des ersten Abschnitts.

Es versteht sich, dass alle Halbleiterschichten einer aus GaAs bestehenden oder GaAs umfassenden Halbleiterdiode, also insbesondere die Kathodenschicht, die Anodenschicht und das Driftgebiet, jeweils aus GaAs bestehen oder GaAs zumindest umfassen. Anders ausgedrückt weist jede Halbleiterschicht der III-V-Halbleiterdiode mindestens die Elemente Ga und As auf.

Die Halbleiterschichten werden vorzugsweise mittels Epitaxie erzeugt. In einer Weiterbildung lässt sich die Kathodenschicht oder die Anodenschicht durch eine Substratschicht ausbilden. Vorzugsweise werden auf der Substratschicht weitere III-V-Halbleiterschichten epitaktisch gewachsen, um die III-V Halbleiterdiode auszubilden.

Alternativ umfasst der die III-V Halbleiterdiode wenigstens einen Halbleiterbond. Hierbei werden Oberflächen von zwei GaAs Halleiterscheiben bzw. GaAs-Wafer zusammengefügt.

Vorzugsweise wird die Dotierung der jeweiligen GaAs Halbleiterschichten während der Epitaxie eingebracht. Vorzugsweise wird die Epitaxie mittels MOVPE und / oder LPE durchgeführt.

In einer Weiterbildung wird die Dotierung mittels Ionenimplantation zusätzlich nach dem epitaktischen Wachsen oder alternativ anstelle dem Einbringen während der Epitaxie durchführen.

Außerdem versteht es sich, dass die Halbleiterdiode vorzugsweise weitere Schichten aus anderen Materialien, insbesondere metallische Anschlusskontaktschichten, aufweist. Die Anschlusskontaktschichten bestehen beispielsweise vollständig oder teilweise aus einem Metall, z.B. Gold, oder aus einer Metalllegierung und sind beispielsweise mittels Elektronenstrahlverdampfung oder mittels Sputterns erzeugt.

Zumindest der an eine Anschlusskontaktschicht angrenzende Bereich der Kathodenschicht sowie der Anodenschicht weist bevorzugt eine hohe Dotierstoffkonzentration auf, um eine möglichst niederohmigen Kontakt auszubilden und den Serienwiderstand bzw. die Verlustleistung der Halbleiterdiode so gering wie möglich zu halten.

Das Driftgebiet zeichnet sich durch eine Gesamtbreite von mindestens 10 µm und eine Aufteilung auf zwei Gebiete bzw. Schichten mit unterschiedlicher niedriger Dotierung aus.

Vorzugsweise beträgt die Gesamtbreite mindestens 20 µm oder mindestens 40 µm oder mindestens 60 µm. Die Gesamtbreite teilt sich auf einen schwach p-dotierten und einen schwach n-dotierten Bereich bzw. Schicht auf.

Der p-n Übergang bildet sich somit innerhalb des Driftgebiets und in einem Bereich mit sehr niedrigen Dotierstoffkonzentrationen aus.

Mittels des zweiten Kathodenabschnitts mit einem in Richtung des zweiten Kathodenabschnitts ansteigenden Dotierstoffkonzentrationsverlauf wird der Übergang zwischen dem Driftgebiet und dem hohen Dotierstoffkonzentrationsniveaus des ersten Abschnitts der Kathode gestaltet.

Durch den schrittweisen Dotierstoffkonzentrationsanstieg in dem Übergangsbereich über eine, zwei oder auch mehrere Stufen ist es möglich, Dioden mit einem deutlich verbesserten Abschaltverhalten herzustellen. Es werden Schwingungen in der Strom-Spannungskennlinie beim Abschalten der Diode minimiert

Ein weiterer Vorteil ist, dass sich mit den Dioden mit besonders hohen Sperrspannungen von über 1100 V oder sogar über 1200 V erreichen, kleinen Einschaltwiderständen sowie besonders geringen Kapazitäten pro Fläche realisieren lassen.

In einer Weiterbildung werden in die p-dotierte Driftschicht und / oder die Anodenschicht isolelektrischen bzw. isovalenten Zentren eingebaut, um die Schaltgeschwindigkeit, d.h. den Wechsel zwischen Rückwärts und Vorwärtsrichtung zu erhöhen.

Insbesondere sind Dioden mit einer Sperrverzugsladung (Reverse Recovery Charge) von höchstens 800 nC herstellbar.

In einer ersten Weiterbildung weist die Anodenschicht einen ersten Abschnitt mit einer Dotierstoffkonzentration von mindestens 1•10¹⁷ cm⁻³ und einen zwischen dem ersten Abschnitt und dem Driftgebiet angeordneten zweiten Abschnitt auf.

Der zweite Abschnitt weist eine Schichtdicke von mindestens 1 µm und einen in Richtung des ersten Abschnitts bis zu einem Dotierstoffkonzentrationsmaximum ansteigenden Dotlerstoffkonzentrationsverlauf auf.

Das Dotierstoffkonzentrationsmaximum des zweiten Abschnitts ist kleiner oder gleich der Dotierstoffkonzentration des ersten Abschnitts.

Mittels des zweiten Schichtabschnitts der Anodenschicht wird der Übergang der Dotierstoffkonzentration zwischen dem Driftgebiet und der weiteren Anodenschicht schrittweise oder kontinuierlich ansteigend gestaltet.

In einer Ausführungsform beträgt die Schichtdicke des zweiten Abschnitts der Kathodenschicht und / oder der Anodenschicht höchstens 7 µm oder höchstens 5 µm oder höchstens 3 µm. Eine geringe Schichtdicke ist ausreichend, um beispielsweise das Ausschaltverhalten der Diode zu verbessern, ohne den Serienwiderstand unnötig zu erhöhen.

In einer anderen Ausführungsform ist der Dotierstoffkonzentrationsverlauf des zweiten Abschnitts der Kathodenschicht und / oder der Anodenschicht konkav oder konvex oder linear ausgebildet.

In einer weiteren Ausführungsform weist der Dotierstoffkonzentrationsverlauf des zweiten Abschnitts der Kathodenschicht und / oder der Anodenschicht eine Stufe oder mehrere Stufen auf, wobei In alternativen Weiterbildungen eine Stufe oder mehrere Stufen oder jede Stufe des Dotierstoffkonzentrationsverlaufs eine konvexe Flanke oder eine konkave Flanke oder eine lineare Flanke aufweist.

In einer weiteren Weiterbildung weist jede Stufe eine Tiefe von mindestens 0,2 µm oder von mindestens 0,5 µm auf.

In einer anderen Ausführungsform ändert sich die Dotierstoffkonzentration von Stufe zu Stufe um mindestens einen Faktor 5 oder mindestens um einen Faktor 10.

In einer weiteren Ausführungsform beträgt die Dotierstoffkonzentration des ersten Abschnitts der Kathodenschicht mindestens 8•10¹⁸ cm⁻³ oder mindestens 1•10¹⁹ cm⁻³.

In einer anderen Weiterbildung weist die Anodenschicht einen dritten Abschnitt auf, wobei der dritte Abschnitt auf einer von dem zweiten Abschnitt abgewandten Seite des ersten Abschnitts angeordnet ist und eine Dotierstoffkonzentration von mindestens 5•10¹⁸ cm⁻³ oder von mindestens 1•10¹⁹ cm⁻³ aufweist.

Durch die Auftellung der Anodenschicht in zwei Teilschichten ist es möglich, mittels einer hohen Dotierung den ohmschen Widerstand zu dem Anschlusskontakt möglichst gering zu halten und gleichzeitig mittels einer etwas niedrigeren Dotierung angrenzend an das Driftgebiet einen Potentialgradienten zwischen der Kathodenschicht und der Anodenschicht zu realisieren und das Abschaltverhalten weiter zu verbessern.

In einer weiteren Weiterbildung weist die Kathodenschicht und / oder die Anodenschicht einer Schichtdicke von mindestens 2 µm oder mindestens 5 µm oder mindestens 20 µm auf.

In einer anderen Ausführungsform ist die Kathodenschicht oder die Anodenschicht als Substrat ausgebildet.

In einer Weiterbildung ist der jeweilige Dotierstoffkonzentrationsverlauf in den Driftschichten entweder konkav oder konvex oder linear oder stufenförmig ausgebildet.

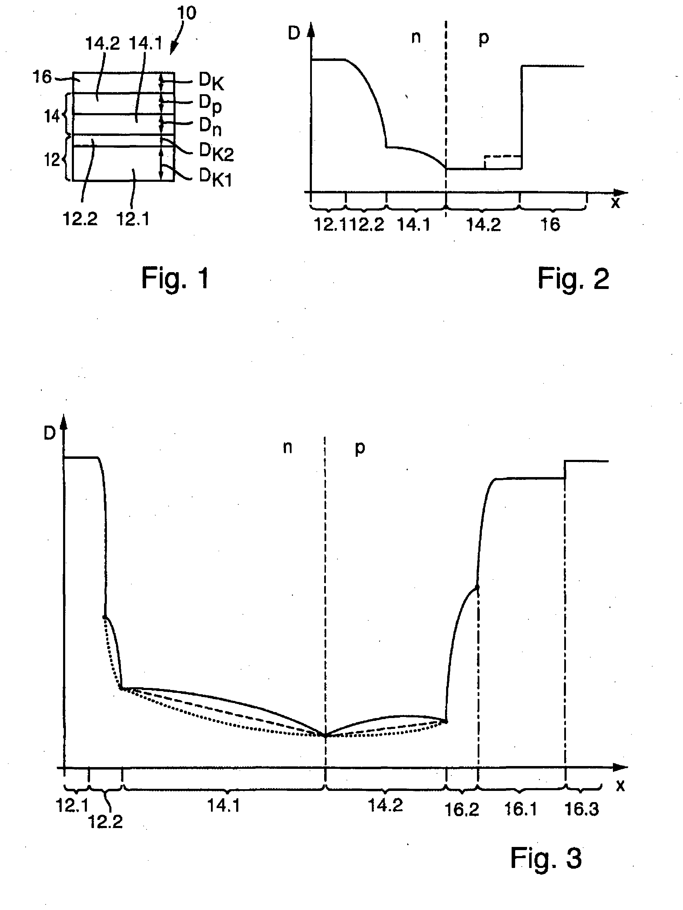

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht auf eine erste Ausführungsform einer stapelförmigen III-V-Halblelterdiode,
- Figur 2: eine Ansicht auf eine zweite Ausführungsform eines Dotierstoffkonzentrationsverlaufs entlang des III-V-Schichtstapels der Halbleiterdiode.
- Figur 3: eine Ansicht auf eine weitere Ausführungsform eines Dotierstoffkonzentrationsverlaufs entlang des III-V-Schichtstapels der Halbleiterdiode,
- Figur 4: eine Ansicht auf eine weitere Ausführungsform eines Dotierstoffkonzentrationsverlaufs entlang des III-V-Schichtstapels der Halbleiterdiode,
- Figur 5: eine Ansicht auf eine weitere Ausführungsform eines Dotierstoffkonzentrationsverlaufs entlang des III-V-Schichtstapels der Halbleiterdiode.
Die Abbildung der Figur 1 zeigt eine erste Ausführungsform einer stapelförmigen und GaAs aufweisenden oder aus GaAs bestehenden III-V-Halbleiterdiode 10. Die Halbleiterdiode 10 weist in der genannten Reihenfolge eine Kathodenschicht 12, ein Driftgebiet 14 und eine Anodenschicht 16 mit einer Schichtdicke D_{A} auf.

Die Kathodenschicht 12 weist einen aus einer hoch n-dotierten Substratschicht gebildeten ersten Abschnitt 12.1 mit einer Schichtdicke D_{K1} von 50 µm bis 250 µm und einer konstanten oder zumindest im Wesentlichen konstanten Dotierstoffkonzentration von mindestens 1•10¹⁸ cm⁻³, bevorzugt von mindestens 8•10¹⁸ cm⁻³ auf.

Außerdem weist die Kathodenschicht 12 einen zwischen dem ersten Abschnitt 12.1 und dem Driftgebiet 14 angeordneten zweiten Abschnitt 12.2 mit einer deutlich niedrigeren Schichtdicke D_{K2} von mindestens 1 µm auf. Die Dotierstoffkonzentration eines n-Dotierstoffs des zweiten Abschnitt 12.2 steigt in Richtung des ersten Abschnitts 12.2 bis zu einem Dotierstoffkonzentrationsmaximum an, wobei das Dotierstoffkonzentrationsmaximum kleiner als die Dotierstoffkonzentration des ersten Abschnitts 12.1 ist.

Das Driftgebiet 14 teilt sich in eine an die Kathodenschicht 12 angrenzende schwach n-dotierte Driftschicht 14.1 mit einer Schichtdicke Dₙ und eine zwischen der n-dotierten Driftschicht 14.1 und der Anodenschicht 16 angeordnete schwach p-dotierte Driftschicht 14.2 mit einer Schichtdicke Dₚ auf.

Die Schichtdicke Dₙ der n-dotierten Driftschicht 14.1 beträgt mindestens 5 µm, bevorzugt mindestens 40 µm. Eine Dotierstoffkonzentration nimmt von einem Dotierstoffkonzentrationsmaximum von höchstens 8•10¹⁵ cm⁻³, bevorzugt von höchstens 2•10¹⁵ cm⁻³, in Richtung der p-dotierten Driftschicht 14.2 ab.

Die Schichtdicke Dₚ der p-dotierten Driftschicht 14.2 beträgt mindestens 5 µm, bevorzugt mindestens 20 µm. Bevorzugt beträgt die Schichtdicke Dₚ der p-dotierten Driftschicht 14.2 die Hälfte oder ein Drittel der Schichtdicke Dₙ der n-dotierten Driftschicht 14.1. Eine Dotierstoffkonzentration der p-dotierten Driftschicht 14.2 nimmt in Richtung der Anodenschicht 16 bis auf ein Dotierstoffkonzentrationsmaximum von mindestens 1•10¹⁷ cm⁻³ oder mindestens 1•10¹⁸ cm⁻³ zu.

Ausgehend von dem den ersten Abschnitt 12.1 der Kathodenschicht 12 ausbildenden Substrat sind die weiteren Schichten bevorzugt epitaktisch erzeugt.

In der Abbildung der Figur 2 ist eine erste Ausführungsform des Dotierstoffkonzentrationsverlaufs entlang der stapelförmigen III-V-Halbleiterdiode 10 In Figur 1 dargestellt.

Dargestellt ist ein Dotierstoffkonzentrationsverlauf D über eine Position x entlang des Stapels der Halbleiterdiode 10.

Ausgehend von einer hohen und konstanten n-Dotierung entlang des ersten Abschnitts 12.1 der Kathodenschicht 12 sinkt die Dotierstoffkonzentration der n-Dotierstoffe entlang des zweiten Abschnitts 12.2 sowie entlang der n-Driftschicht 12 ab. Die Abnahme ist jeweils konvex ausgebildet und erfolgt im Bereich der n-Driftschicht 14.1 deutlich langsamer als im Bereich des zweiten Abschnitts 12.2 der Kathodenschicht 12.

Der p-n Übergang bildet sich zwischen der n-dotierte Driftschicht 14.1 und der p-dotierte Driftschicht 14.2 an. Die p-dotierte Driftschicht 14.2 weist im dargestellten Ausführungsbeispiel eine konstante oder stufenförmige, sehr niedrige Dotierstoffkonzentration von p-Dotierstoffen auf. Die sich anschließende Anodenschicht weist eine konstante und sehr hohe Dotierstoffkonzentration von p-Dotierstoffen auf.

In der Abbildung der Figur 3 ist eine weitere Ausführungsform der III-V-Halbleiterdiode 10 anhand des Dotierstoffkonzentrationsverlaufs dargestellt. Im Folgenden werden nur die Unterschiede zu der Figur 2 dargestellt.

Der Dotierstoffkonzentrationsabfall des zweiten Abschnitts 12.2 der Kathodenschicht 12 weist zwei Stufen mit jeweils konvexer Flanke auf.

Der Dotierstoffkonzentrationsverlauf der n-dotierten Driftschicht 14.1 steigt in Richtung der Kathodenschicht 12 konvex oder linear oder konkav an. Auch der Dotierstoffkonzentrationsverlauf der p-dotierten Driftschicht 14.2 steigt in Richtung der Anodenschicht 16 konvex oder linear oder konkav an.

Zusätzlich weist die Anodenschicht einen ersten Abschnitt 16.1 mit einer ersten konstanten Dotierstoffkonzentration, einen zwischen dem ersten Abschnitt 16.1 und dem Driftgebiet 14 angeordneten zweiten Abschnitt 16.1 mit einem in Richtung des ersten Abschnitts 16.1 über zwei Stufen ansteigenden Dotierstoffkonzentrationsverlauf sowie einen dritten Abschnitt 16.3 auf. Der dritte Abschnitt 16.1 ist auf der dem zweiten Abschnitt 16.2 abgewandten Seite des ersten Abschnitts 16.1 angeordnet und weist eine konstante Dotierstoffkonzentration auf, wobei die Dotierstoffkonzentration des dritten Abschnitts 16.3 höher als die Dotierstoffkonzentration des ersten Abschnitts 16.1 ist

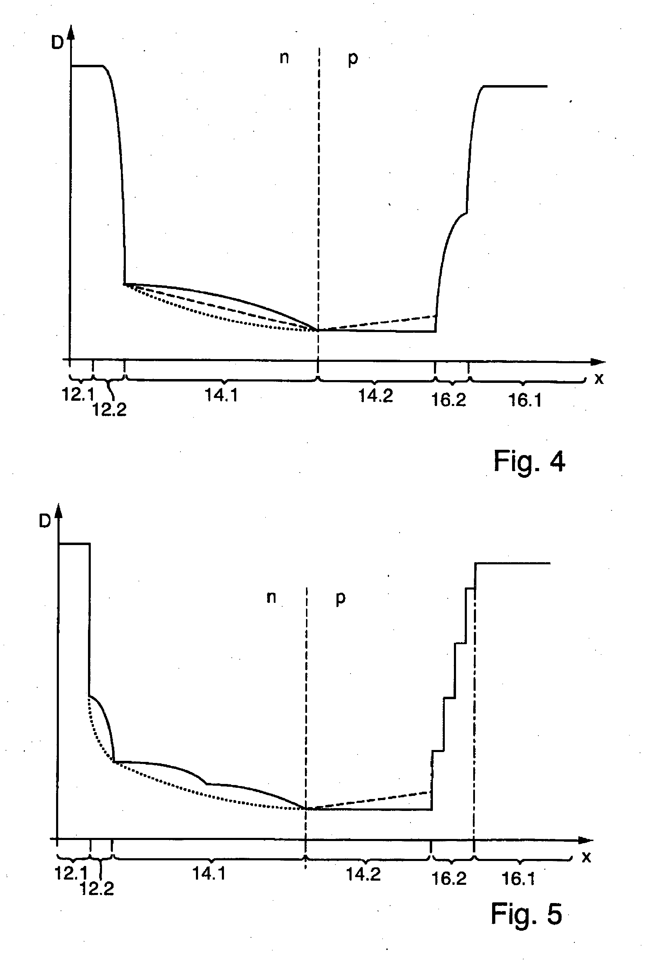

In der Abbildung der Figur 4 ist eine weitere Ausführungsform der III-V-Halbleiterdiode 10 anhand des Dotierstoffkonzentratlonsverlaufs dargestellt. Im Folgenden werden nur die Unterschiede zu der Figur 3 dargestellt.

In der dargestellten Ausführungsform weist nur der zweite Abschnitt 16.1 der Anodenschicht 16 einen stufigen Verlauf auf, während der Dotierstoffkonzentrationsanstieg des zweiten Abschnitts 12.2 der Kathodenschicht 12 konvex verläuft.

In der Abbildung der Figur 5 ist eine weitere Ausführungsform der III-V-Halbleiterdiode 10 anhand des Dotierstoffkonzentrationsverläufs dargestellt. Im Folgenden werden nur die Unterschiede zu der Figur 4 dargestellt.

Der Dotierstoffkonzentrationsverlauf der zweite Abschnitt 12.2 der Kathodenschicht 12 steigt bis zu einem Dotierstoffkonzentrationsmaximum an, wobei das Dotierstoffkonzentrationsmaximum deutlich geringer ist als die Dotierstoffkonzentration des ersten Abschnitts 12.1, so dass sich zwischen dem ersten Abschnitt 12.1 und dem zweiten Abschnitt 12.2 ein Dotierstoffkonzentrationssprung ausbildet.

Entlang der n-dotierten Driftschicht weist der Dotierstoffkonzentrationsverlauf in einer dargestellten Ausführungsform zwei Stufen mit jeweils konvexer Flanke auf.

Entlang des zweiten Abschnitts 16.2 der Anodenschicht 16 steigt die Dotierstoffkonzentration über mehrere Stufen mit jeweils linearer Flanke, insbesondere über rechteckig ausgebildete Stufen, an. Die Kathodenschicht 16 weist in dem dargestellten Ausführungsbeispiel keinen dritten Abschnitt 16.3 auf.

## Patentansprüche

1. Stapelförmige Halbleiterdiode (10) umfassend oder bestehend aus GaAs, aufweisend
- eine hoch n-dotierte Kathodenschicht (12),
- eine hoch p-dotierte Anodenschicht (16) und
- ein zwischen der Kathodenschicht (12) und der Anodenschicht (16) angeordnetes Driftgebiet (14) mit einer Dotierstoffkonzentration von höchstens 8•10¹⁵ cm⁻³,
**dadurch gekennzeichnet, dass**
- das Driftgebiet (14) eine niedrig n-dotierte Driftschicht (14.1) und eine zwischen der n-dotierten Driftschicht (14.1) und der Anodenschicht (16) angeordnete niedrig p-dotierte Driftschicht (14.2) aufweist,
- beide Driftschichten jeweils eine Schichtdicke von mindestens 5 µm aufweisen,
- die Kathodenschicht (12) einen ersten Abschnitt (12.1) mit einer konstanten oder zumindest im Wesentlichen konstanten Dotierstoffkonzentration von mindestens 1•10¹⁷ cm⁻³ oder von mindestens 1•10¹⁸ cm⁻³ und einen zwischen dem ersten Abschnitt (12.1) und dem Driftgebiet (14) angeordneten zweiten Abschnitt (12.2) aufweist, wobei
- der zweite Abschnitt (12.2) eine Schichtdicke (D_{K2}) von mindestens 1 µm und einen in Richtung des ersten Abschnitts (12.1) bis zu einem Dotierstoffkonzentrationsmaximum ansteigenden Dotierstoffkonzentrationsverlauf aufweist und
- das Dotierstoffkonzentrationsmaximum kleiner oder gleich der Dotierstoffkonzentration des ersten Abschnitts (12.1) ist.

2. Stapelförmige Halbleiterdiode (10) nach Anspruch 1, **dadurch gekennzeichnet, dass** die Anodenschicht (16) einen ersten Abschnitt (16.1) mit einer Dotierstoffkonzentration von mindestens 1•10¹⁷ cm⁻³ und einen zwischen dem ersten Abschnitt (16.1) und dem Driftgebiet (14) angeordneten zweiten Abschnitt (16.2) aufweist, wobei der zweite Abschnitt (16.2) eine Schichtdicke (D_{A2}) von mindestens 1 µm und einen in Richtung des ersten Abschnitts (16.1) bis zu einem Dotierstoffkonzentrationsmaximum ansteigenden Dotierstoffkonzentrationsverlauf aufweist und das Dotierstoffkonzentrationsmaximum kleiner oder gleich der Dotierstoffkonzentration des ersten Abschnitts (16.1) ist.

3. Stapelförmige Halbleiterdiode (10) nach Anspruch 1 oder 2, **dadurch gekennzeichnet, dass** die Schichtdicke (D_{A2}) des zweiten Abschnitts (12.2, 16.2) höchstens 7 µm oder höchstens 5 µm oder höchstens 3 µm beträgt.

4. Stapelförmige Halbleiterdiode (10) nach einem der vorstehenden Ansprüche, **dadurch gekennzeichnet, dass** der Dotierstoffkonzentrationsverlauf des zweiten Abschnitts (12.2, 16.2) konkav oder konvex oder linear ausgebildet ist.

5. Stapelförmige Halbleiterdiode (10) nach einem der vorstehenden Ansprüche, **dadurch gekennzeichnet, dass** der jeweilige Dotierstoffkonzentrationsverlauf in den Driftschichten (14.1, 14.2) konkav oder konvex oder linear oder stufenförmig ausgebildet sind.

6. Stapelförmige Halbleiterdiode (10) nach einem der vorstehenden Ansprüche, **dadurch gekennzeichnet, dass** der Dotierstoffkonzentrationsverlauf des zweiten Abschnitts (12.2, 16.2) eine Stufe oder mehrere Stufen aufweist.

7. Stapelförmige Halbleiterdiode (10) nach Anspruch 6, **dadurch gekennzeichnet, dass** eine Stufe oder mehrere Stufen oder jede Stufe des Dotierstoffkonzentrationsverlaufs eine konvexe Flanke oder eine konkave Flanke oder eine lineare Flanke aufweist.

8. Stapelförmige Halbleiterdiode (10) nach Anspruch 6 oder 7, **dadurch gekennzeichnet, dass** jede Stufe eine Tiefe von mindestens 0,2 µm oder von mindestens 0,5 µm aufweist.

9. Stapelförmige Halbleiterdiode (10) nach einem der Ansprüche 6 bis 8, **dadurch gekennzeichnet, dass** sich die Dotierstoffkonzentration von Stufe zu Stufe um mindestens einen Faktor 5 oder mindestens um einen Faktor 10 ändert.

10. Stapelförmige Halbleiterdiode (10) nach einem der vorstehenden Ansprüche, **dadurch gekennzeichnet, dass** die Dotierstoffkonzentration des ersten Abschnitts (12.1) der Kathodenschicht (12) mindestens 8•10¹⁸ cm⁻³ oder mindestens 1•10¹⁹ cm⁻³ beträgt.

11. Stapelförmige Halbleiterdiode (10) nach einem der vorstehenden Ansprüche, **dadurch gekennzeichnet, dass** die Anodenschicht (16) einen dritten Abschnitt (16.3) aufweist, wobei der dritte Abschnitt (16.3) auf einer von dem zweiten Abschnitt (16.2) abgewandten Seite des ersten Abschnitts (16.1) angeordnet ist und eine Dotierstoffkonzentration von mindestens 5•10¹⁸ cm⁻³ oder von mindestens 1•10¹⁹ cm⁻³ aufweist.

12. Stapelförmige Halbleiterdiode (10) nach einem der vorstehenden Ansprüche, **dadurch gekennzeichnet, dass** die Kathodenschicht (12) und / oder die Anodenschicht (16) einer Schichtdicke von mindestens 2 µm oder mindestens 5 µm oder mindestens 20 µm aufweist.

13. Stapelförmige Halbleiterdiode (10) nach einem der vorstehenden Ansprüche, **dadurch gekennzeichnet, dass** die Kathodenschicht (12) oder die Anodenschicht (16) als Substrat ausgebildet ist.
